# EUROPEAN PATENT SPECIFICATION

(11) **EP 0 999 579 B1**
(45) Date of publication and mention of the grant of the patent: **30.05.2007**
(21) Application number: 99308423.5
(22) Date of filing: 25.10.1999
(51) Int. Cl.: H01L 21/02, H01L 27/08, H01L 23/522, H01L 23/64

(54) **An inductor or low loss interconnect in an integrated circuit**
Induktivität oder Leiterbahn mit geringem Verlust in einer integrierten Schaltung
Dispositif d'inductance ou d' interconnecxion à faibles pertes dans des circuits intégrés

(30) Priority: 04.11.1998 US 106945 P; 15.03.1999 US 124478 P; 30.08.1999 US 386132
(43) Date of publication of application: 10.05.2000
(73) Proprietor: LUCENT TECHNOLOGIES INC., Murray Hill, New Jersey 07974-0636 (US)
(72) Inventor: Archer, Vance Dolvan, Asbury Park, New Jersey 07712 (US); Belk, Nathan, Scotch Plains, New Jersey 07076 (US); Carroll, Michael Scott, Orlando, Florida 32837 (US); Cochran, William Thomas, Clermont, Florida 34711 (US); Dennis, Donald C., Orlando, Florida 32835 (US); Frei, Michel Ranjit, Berkeley Heights, New Jersey 07922 (US); Gregor, Richard William, Winter Park, Florida 32789 (US); Lin, Wen, Allentown, Pennsylvania 18103 (US); Moinian, Shahriar, Reading, Pennsylvania 19601 (US); Nagy, William John, Orlando, Pennsylvania 32836 (US); Ng, Kwok K., Warren, New Jersey 07059 (US); Pinto, Mark Richard, Summit, New Jersey 07901 (US); Rich, David Arthur, Whitehall, Pennsylvania 18052 (US); Xie, Ya-Hong, Beverly Hills, California 90211 (US); Goldthorp, David Clayton, Reiffton, Pennsylvania 19601 (US)
(74) Representative: Williams, David John

(56) References cited:
- WO-A-98/22981
- WO-A-99/33114
- US-A- 4 458 158
- US-A- 5 918 121
- YUE C P ET AL: "A study on substrate effects of silicon-based RF passive components" MICROWAVE SYMPOSIUM DIGEST, 1999 IEEE MTT-S INTERNATIONAL ANAHEIM, CA, USA 13-19 JUNE 1999, PISCATAWAY, NJ, USA,IEEE, US, 13 June 1999 (1999-06-13), pages 1625-1628, XP010343589 ISBN: 0-7803-5135-5
- BURGHARTZ J N ET AL: "Monolithic spiral inductors fabricated using a VLSI Cu-damascene interconnect technology and low-loss substrates" ELECTRON DEVICES MEETING, 1996., INTERNATIONAL SAN FRANCISCO, CA, USA 8-11 DEC. 1996, NEW YORK, NY, USA,IEEE, US25, 8 December 1996 (1996-12-08), pages 99-102, XP010207545 ISBN: 0-7803-3393-4
- ERZGRAEBER H B ET AL: "NOVEL BURIED OXIDE ISOLATION FOR MONOLITHIC RF INDUCTORS ON SILICON" INTERNATIONAL ELECTRON DEVICES MEETING 1998. IEDM TECHNICAL DIGEST. SAN FRANCISCO, CA, DEC. 6 - 9, 1998, NEW YORK, NY: IEEE, US, 6 December 1998 (1998-12-06), pages 535-539, XP000859430 ISBN: 0-7803-4775-7

## Description

### Field of the Invention

The present invention relates generally to integrated circuits and, more particularly, to an inductor and a method of manufacturing an inductor in an integrated circuit.

### Background of the Invention

The integration of high-Q inductors with high-density CMOS technologies faces limitations because of conflicts in substrate requirements. Some CMOS technologies use standard substrates that include a P- doped epitaxial layer formed on a P+ bulk substrate. The P+ bulk substrate has a resistivity as low as 1x10¹⁹ cm⁻³. Inductors fabricated using conventional back-end processes are severely degraded because of eddy current losses in the standard substrate.

For example, inductors formed on standard substrates have been reported having a maximum quality factor Q of approximately three (3). Quality factor Q is a measure of inductor performance. A higher Q signifies a better inductor while a lower Q signifies a worse inductor. Although the P+ epitaxial layer degrades inductor performance, it suppresses latchup and provides impurity gettering in CMOS devices. Therefore, changing to a non-degenerate substrate to increase Q translates into a reduction in device density and possible yield loss. Further, a change to a higher resistivity substrate would cause shifts in device characteristics and result in new design rules to satisfy the new latchup conditions. This would require redesign of existing circuit libraries.

The state of the art is represented by:
WO 98/22981 A (Philips Electronics NV; Philips Norden AB (SE)) 28 May 1998.
Yue C P et al: 'A Study on Substrate Effects of Silicon-based RF Passive Components' Microwave Symposium Digest, 1999 IEEE MTT-S International Anaheim, CA, USA 13-19 June 1999, Piscataway, NJ, USA, IEEE, US, 13 June 1999, pages 1625-1628, XP010343589 ISBN: 0-7803-5135-5.
Burghartz J N et al: 'Monolithic Spiral Inductors Fabricated using a VLS1 Cu-Damascene Interconnect Technology and Low-Loss Substrates' Electron Devices Meeting, 1996, International San Francisco, CA, USA 8-11 Dec. 1996, New York, NY, USA, IEEE, US, 8 December 1996, pages 99-102, XP010207545 ISBN: 0-7803-3393-4.
WO 99/33114 A (Wolff Andre; Grabolla Thomas (DE); Bolze Klaus Detlef (DE); Erzgra) 1 July 1999.

### Summary of the Invention

In accordance with one aspect of the invention there is provided a method according to claim 1.
In accordance with another aspect of the present invention there is provided an integrated circuit according to claim 6.

The present invention provides an integrated circuit with a buried layer for increasing the Q of an inductor formed in the integrated circuit. In one illustrative embodiment, an inductor is formed in an integrated circuit having a substrate that includes a P+ buried layer formed between a P- epitaxial layer and a p bulk substrate. In other words, the substrate includes a highly doped buried layer formed between less doped layers. This provides a high Q inductor while preserving device and latchup characteristics. The present invention further relates to providing an increased thickness metal layer to form the body of the inductor to further increase Q.

The present further relates to a low loss interconnect (transmission line). The interconnect is formed in the same manner as the inductor except that the metal layer is not formed in a spiral shape to form an inductor.

It is to be understood that both the foregoing general description and the following detailed description are exemplary, but are not restrictive, of the invention.

### Brief Description of the Drawing

The invention is best understood from the following detailed description when read in connection with the accompanying drawing. It is emphasized that, according to common practice in the semiconductor industry, the various features of the drawing are not to scale. On the contrary, the dimensions of the various features are arbitrarily expanded or reduced for clarity. Included in the drawing are the following figures:
Fig. 1 is a schematic diagram along line 1-1 of the integrated circuit shown in Fig. 2 including an inductor according to an illustrative embodiment of the present invention;
Fig. 2 is a top view of the integrated circuit;
Fig. 3 is a flowchart diagram for manufacturing an integrated circuit according to an illustrative embodiment of the present invention;
Fig.4 is a flowchart diagram for forming a buried layer according to a first illustrative embodiment;
Figs. 5 and 6 are schematic diagrams illustrating the process of Fig. 4;
Figs. 7 and 8 are flowchart diagrams for forming the buried layer according to second and third illustrative embodiments;
Figs. 9 and 11 are charts illustrating different aspects of the present invention;
Fig. 12a is a flow chart diagram illustrating the formation of a conductive layer according to an illustrative embodiment of the present invention;
Figs. 12b-12e are schematic diagrams illustrating the steps shown in Fig. 12a;
Fig. 12f is a flow chart diagram illustrating the formation of a conductive layer according to a further illustrative embodiment of the present invention;
Figs. 13, 14, 15, and 10 are charts illustrating experimental data of an inductor formed according to an embodiment of the present invention; and
Fig. 16 is a micrograph of the experimental inductor.

### Detailed Description of the Invention

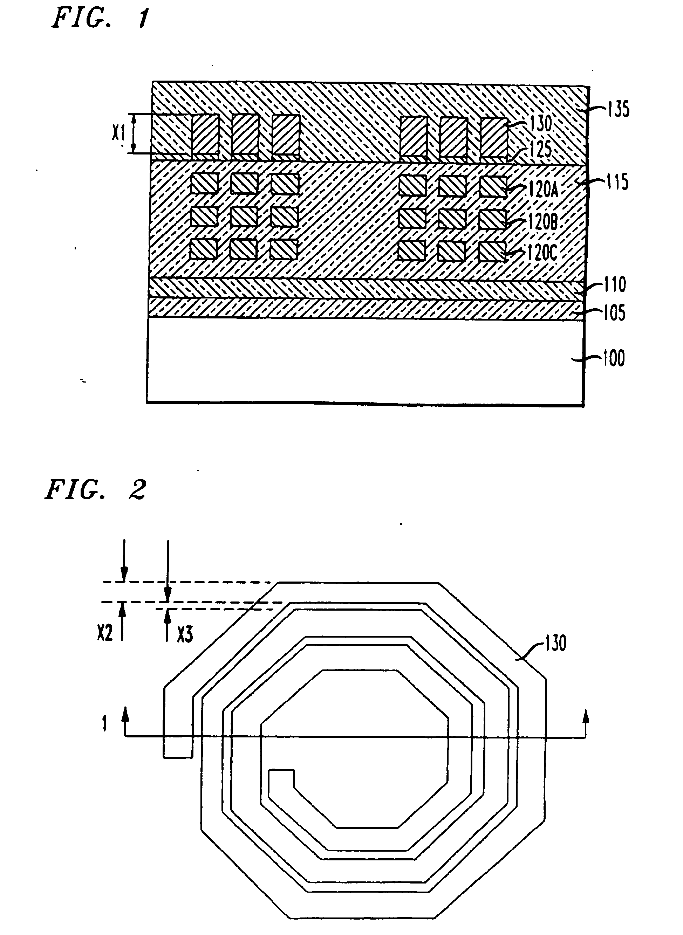

Briefly, the present invention is directed to an integrated circuit including an inductor or transmission line. As is shown in Figs. 1 and 2, the inductor comprises a buried layer 105 and one or more conductive layers 120a, 120b, 120c, 130. The thickness X1 of the conductive layer 130 may be from .5 µm to 6 µm, 1 µm to 5 µm, or approximately 3 µm. The buried layer 105 is positioned between lower doped layer 110 and a lower doped bulk substrate 100. The buried layer 105 is more highly doped than the lower doped layer 110 and the bulk substrate 100. The lower doped layer 110 can be highly resistive and the bulk substrate 100 can be highly resistive. The buried layer 105 is typically more conductive than the bulk substrate 100. The doping of the buried layer 105 is selected to increase the quality factor Q of the inductor and maintain latch-up resistance. One or more of the conductive layers can have an increased thickness to improve Q. In the case of interconnects (transmission lines), the interconnects are formed in the same manner as the inductor including the buried layer 105, the lower doped layer 110, and the lower doped bulk substrate 100 except that the conductive layer (corresponding to layer 130) is not formed in a spiral shape to form an inductor.

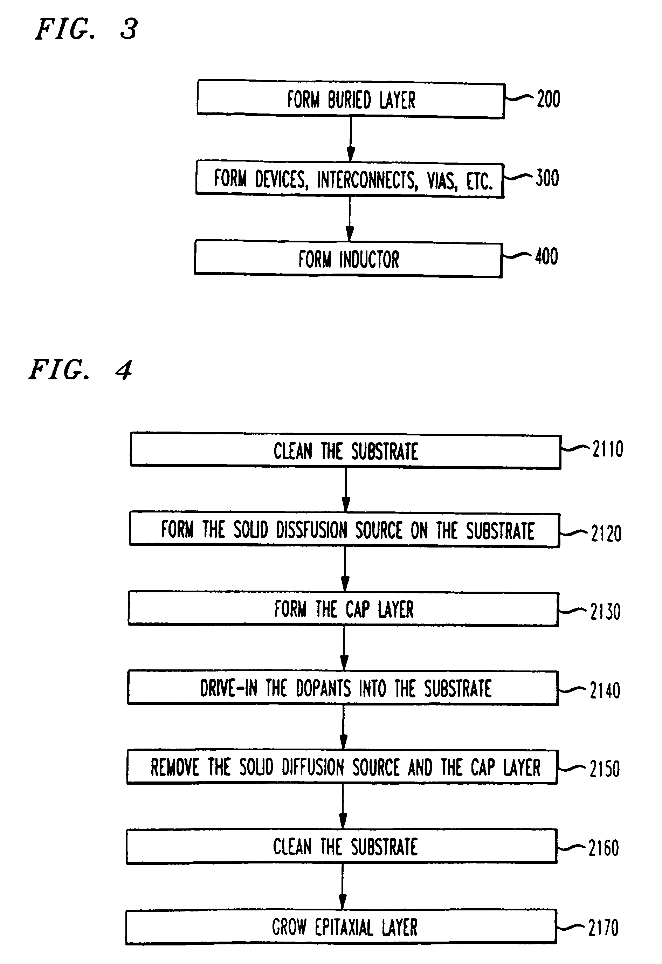

The illustrative embodiment provides high Q inductors while preserving latchup characteristics and CMOS current and voltage characteristics. The illustrative embodiment is particularly useful for super chip integration as it enables RF integration while maintaining existing CMOS circuit libraries. The present invention is described in greater detail below with reference to Fig. 3 and continuing reference to Figs. 1 and 2.

Fig. 3 is a flowchart diagram describing the process for forming an integrated circuit including an inductor. At step 200, the buried layer 105 is formed. The process for forming buried layer 105 is described below with reference to Fig. 4. At step 2110, shown in Fig.4, the bulk substrate 100 is cleaned using, for example, a brush scrub as is well known. The bulk substrate is, for example, a P- silicon substrate that is doped to a concentration less than approximately 1x10¹⁶ cm⁻³ and preferable approximately 1x10¹⁵ cm⁻³. The dopant may be boron or another suitable dopant. The bulk substrate is also cleaned using, for example, a 100:1 HF clean (a solution containing one hundred parts water to one part hydrofluoric acid).

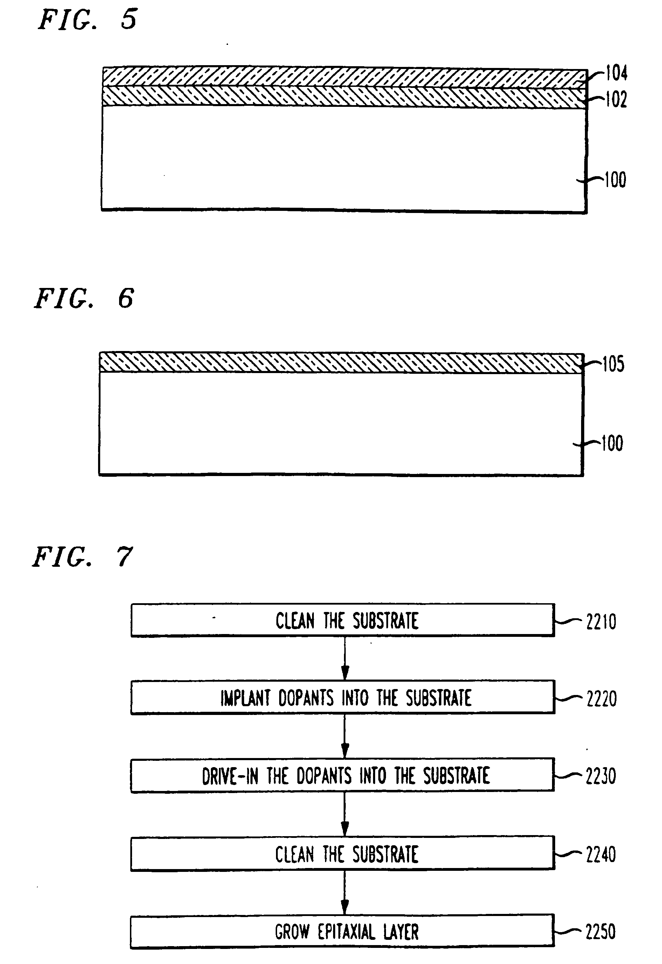

At step 2120, a solid diffusion source 102 (shown in Fig. 5) is formed on the substrate 100. The dopant is selected to subsequently form the P+ buried layer 105 having a doping concentration greater than or equal to approximately 1x10¹⁸ cm⁻³ (≥ 1x10¹⁸ cm⁻³). For example, the diffusion source 102 may be a 5000 Å thick layer of borosilicate glass having an 8% concentration of boron. Next, at step 2130, a cap layer 104 (shown in Fig. 5) is formed on the diffusion source 102 to inhibit out gassing of dopants from the diffusion source 102 during subsequent processing steps. For example, the cap layer 104 may be a 2500 Å thick layer of undoped silicate glass.

At step 2140, the bulk substrate 100 is annealed to drive the dopants into the bulk substrate 100 from the diffusion source 102 to form buried layer 105 (shown in Fig. 6). For example, the substrate 100 may be heated in a nitrogen (N₂) atmosphere for 20 minutes at 950°C. Subsequently, at step 2150, the cap layer 104 and the solid diffusion source 102 are removed (shown in Fig. 6) using a 15:1 HF etch. At step 2160, the substrate 100 is cleaned and, at step 2170, a P- epitaxial layer 110 is formed on the buried layer 105. The P- epitaxial layer is formed using well-known processes. The doping concentration of the P- epitaxial layer is less than 1x10¹⁶ cm⁻³ or approximately 1x10¹⁵ cm⁻³. The thickness of the epitaxial layer 110 is between approximately 1µm to 10µm, 1µm to 5µm, 1µm to 3µm, 2µm, or 4µm. The thickness of the buried layer 105 is between approximately 1µm to 4µm and preferably 3µm.

Fig. 7 illustrates an alternative process for forming the buried layer 105. At step 2210, the substrate 100 is cleaned using, for example, a brush scrub. The substrate is, for example, silicon that is doped with boron to a concentration of less than 1x10¹⁶ cm⁻³ and preferably approximately 1x10¹⁵ cm⁻³. The substrate is also cleaned using, for example, a 100:1 HF clean.

At step 2220, dopants are implanted into the substrate using standard practices. The dopant is boron implanted at an energy of 5 KeV. The dopant is selected to form a P+ buried layer 105 having a doping concentration greater than 1x10¹⁸ cm⁻³. Next, at step 2230, the substrate 100 is annealed to drive the dopants into the substrate 100 to form buried layer 105. Subsequently, at step 2240, the substrate 100 is cleaned and, at step 2250, a P- epitaxial layer 110 is grown on the buried layer 105. The P- epitaxial layer is formed using well-known processes. The doping of the P- epitaxial layer is less than 1x10¹⁶ cm⁻³ and preferably approximately 1x10¹⁵ cm⁻³.

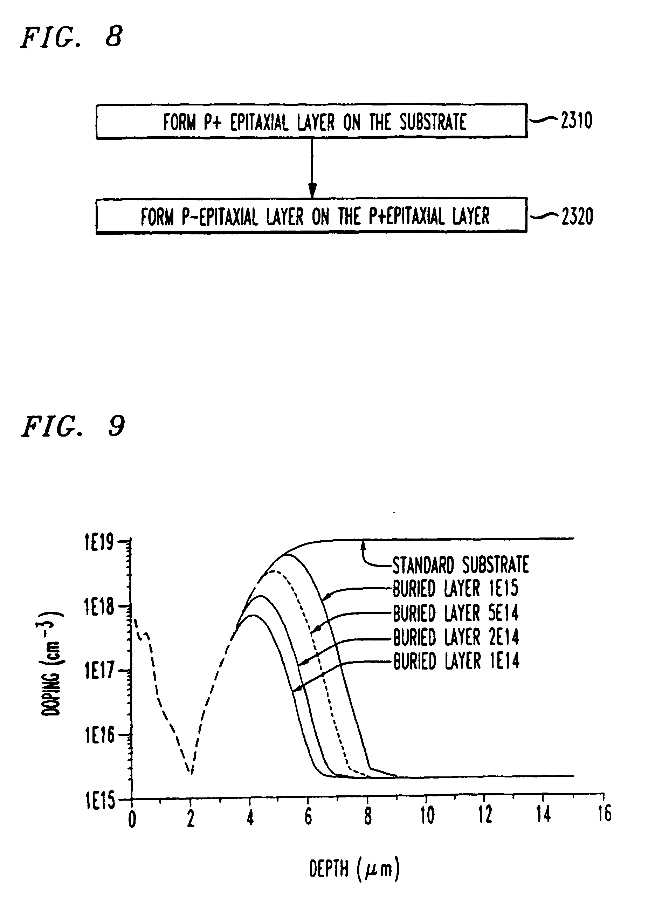

Fig. 8 illustrates a further alternative embodiment to form buried layer 105. At step 2310, a P+ epitaxial layer is grown on the substrate 100. At step 2320, a P- epitaxial layer 110 is grown on the P+ epitaxial layer. The P+ epitaxial layer forms the buried layer 105. The P+ epitaxial layer may be formed in the same chamber using the same process to form the P- epitaxial layer except that the doping of the layers is changed. Both the P+ and P- epitaxial layers are, for example, epitaxially grown silicon where the P+ epitaxial layer is more heavily doped with boron. This is accomplished by varying the amount of boron in the source gas when forming the epitaxial layers. The doping of the buried layer is greater than 1x10¹⁸ cm⁻³ and the doping of the P- epitaxial layer is approximately 1x10¹⁵ cm⁻³.

The two step process shown in Fig. 8 provides a simplified process to produce a substrate that can be used to form an inductor having a higher Q. As a result, the speed of producing the substrates may be increased while reducing the costs. Further, the performance of the substrate can be easily tailored to improve latch-up by thickening the buried layer 105. Alternatively, Q may be increased by decreasing the thickness of the buried layer 105. This two step process may be performed in a single epitaxial chamber.

Fig. 9 compares the vertical doping profiles of a standard substrate and a modified substrate having four different doping concentrations. A modified substrate is the combination of bulk substrate 100, buried layer 105, and lower doped layer 110 produced using one of the methods above. The standard substrate is one that includes a bulk substrate and an epitaxial layer as is known in the prior art. The buried layer 105 is positioned near the interface of the bulk substrate 100 and the lower doped layer 110. The buried layer is formed so that the original profile of the standard substrate is reproduced to, for example, a depth of 2 to 5 µm, 2 to 4 µm, or 3 to 4 µm. As a result, transistor current-voltage (I-V) characteristics remain insensitive to the far regions of the substrate 100.

The dopant dose in the buried layer 105 is adjusted as a trade-off between latchup immunity and inductor performance (an increase in Q). A lower dose in the buried layer 105 results in increased shunt resistance and lower latchup immunity because the buried layer 105 contributes to shunting of the base-emitter junction of a lateral npn transistor formed on the substrate.

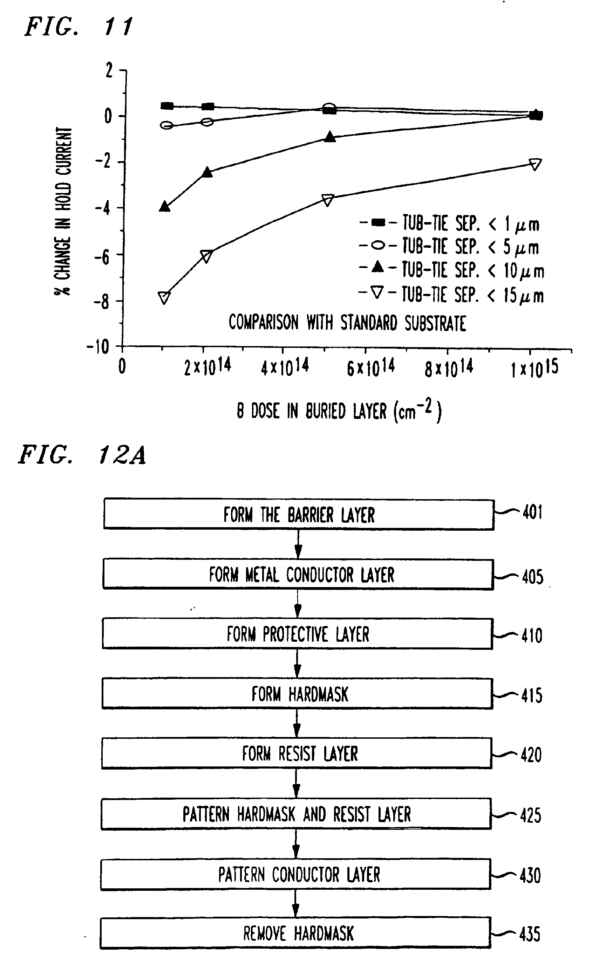

The simulated dose dependence of hold current is illustrated in Fig. 11. A dose of 1x10¹⁵ cm⁻² is sufficient to preserve latchup for a worst case situation where the devices are closely spaced and tub ties are separated by 10 µm. The exact dose may vary depending on layout and design of the integrated circuit.

Returning to Fig. 3, at step 300, transistors, vias and interconnects are formed to produce a desired integrated circuit. The processes used to produce the other component parts of the integrated circuit are well known and omitted for brevity sake. In addition, tubs (p doped tubs and n doped tubs) may be formed in the epitaxial layer using well know processes. A "tub" (alternatively referred to as a "well") is a region that is doped separately than the rest of the substrate.

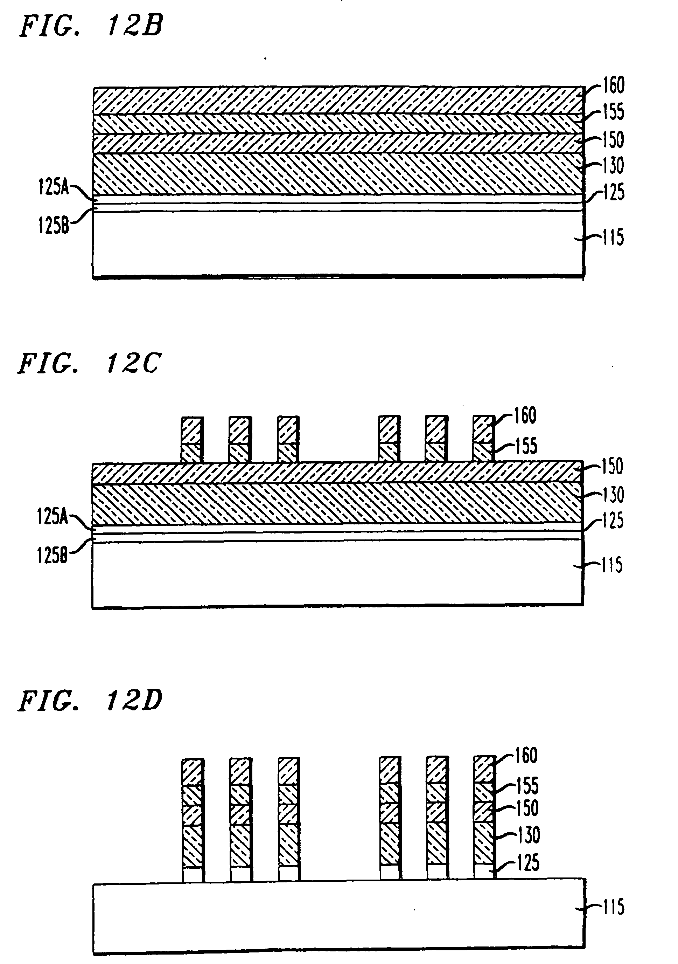

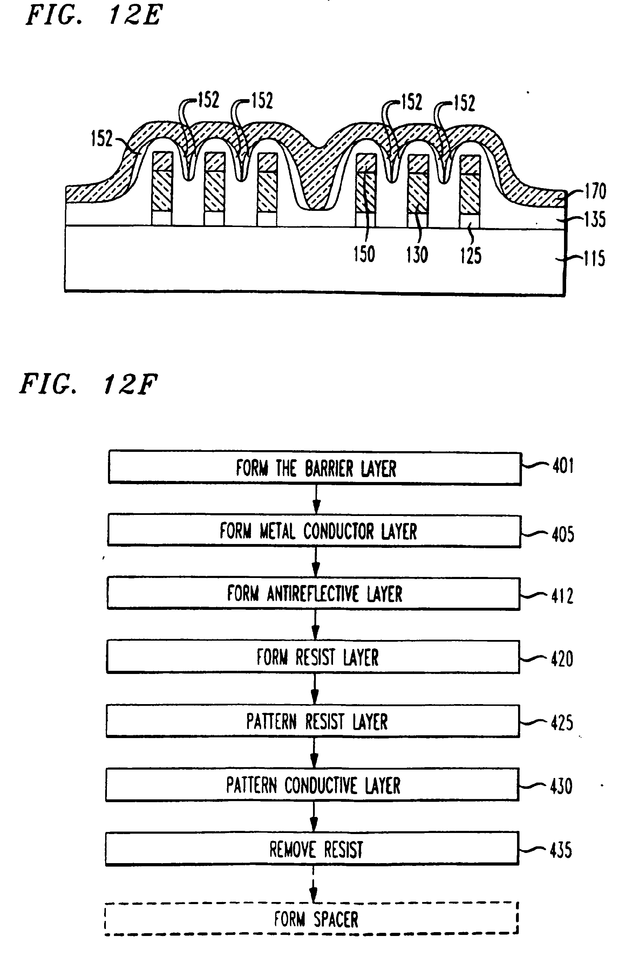

The inductor may be formed from one or more interconnected conductive layers 120a, 120b, 120c, 130. Where more than one conductive layer is used, interconnection (not shown) layers (vias and plugs) between the conductive layers and through the inter-level dielectric layers 115 are provided. The conductive layers are typically formed from metals such as aluminum and tungsten. These layers are deposited and patterned using standard well-known processes except for conductive layer 130. Conductive layer 130 may be the same as or different from the other conductive layers 120a, 120b, 120c. The process to form patterned conductive layer 130 having a thickness of 3 µm is described below with reference to Figs. 12a-12e.

At step 401, a barrier layer 125 is formed over the oxide layer 115. The barrier layer 125 is a barrier between the metal conductive layer and the prior interconnection layer (vias and plugs). An illustrative barrier layer 125 is a titanium nitride layer 125a formed on a titanium layer 125b. The thickness of the titanium nitride layer 125a is, for example, 600Å. The thickness of the titanium layer 125b is, for example, 375Å. At step 405, the conductive layer 130 is formed on the barrier layer 125. The conductive layer 130 is, for example, aluminum. The thickness of the conductive layer 130 is up to approximately 5 µm. The thickness of the conductive layer 130 may also be approximately 1 µm to 5 µm or approximately 2 µm to 4 µm. Further, the thickness of the conductive layer 130 may be approximately 3 µm.

At step 410, a protective layer 150 is formed on the conductive layer 130. The protective layer 150 forms a barrier between the conductive layer 130 and the hardmask that is to be formed on the conductive layer 130. The protective layer 150 is, for example, TiN formed to a thickness of approximately 1000 Å. At step 415, a hardmask layer 155 is formed on the protective layer 150. The material for the hardmask is selected to be resistant to the etching process used to etch the conductive layer 130. The hardmask layer 155 comprises, for example, tungsten which is deposited using sputtering or other well-known deposition techniques. The thickness of the hardmask layer 155 is approximately 5000Å.

At step 420, a resist layer 160 is formed on the hardmask layer 155 and patterned. At step 425, a pattern is formed in the resist layer 160 and is transferred to the hardmask layer 155 by etching. Subsequently, at step 430, the pattern formed in the resist layer 160 and the hardmask layer 155 is transferred to the conductive layer 130 by etching. At step 435, any remaining portion of the resist layer 160 is removed. An etch is then performed to remove excessive sodium and the remaining portion of the hardmask layer 155, and the substrate is cleaned using well-known processes.

Finally, the patterned conductive layer 130 is encapsulated by a cap layer 135. The cap layer is, for example, an oxide deposited using a process that provides good step coverage and gap fill. An exemplary oxide is high-density plasma (HDP) oxide having a thickness of 8000Å. Subsequently, a silicon nitride (SiN) layer is formed on the HDP oxide. Typically, the width X2 (Fig. 2) of the patterned conductive layer lines is 10 µm, spaced apart at a width X3 of 2 µm.

Alternatively, the patterned conductive layer 130 may be formed using an alternative process that does not use a hardmask. This process is shown in Fig. 12f and is the same as the process in Fig. 12a except that steps 410 and 415 are eliminated and replaced by an antireflective layer forming step 412. The antireflective layer is, for example, TiN formed to a thickness of approximately 250 Å. In this case, the resist is formed directly on the protective layer. The resist is formed to a thickness of 2 µm. A highly aluminum selective etch is used to etch layers 125, 130. In addition, a PETEOS spacer 152 may be formed as part of the cap layer 135. A blanket layer of PETEOS approximately 1 µm thick is formed and etched to form the spacers 152 on the side walls of the conductive layer 130 that are encapsulated with the cap layer 135. Subsequently, a silicon nitride (SiN) layer 170 is formed on the HDP oxide...

### Experiment

An inductor was formed using a quarter (.25) micron CMOS process that differed from a typically 0.25 CMOS process in two aspects. First, the substrate 100, previously obtained, by growing several microns of P- epitaxial silicon over a P+ bulk silicon substrate was modified to include a 2x10¹⁵ cm⁻³ bulk substrate 100, a buried layer 105 formed by implantation and diffusion, and an epitaxial layer 110 on the buried layer. No lithography is involved for these steps. The doping concentration of the bulk substrate was approximately 1x10¹⁶ cm⁻³. The doping concentration of the buried layer had a peak concentration on the order of 5x10¹⁸ cm⁻³. The doping concentration of the epitaxial layer was greater than 1x10¹⁵ cm⁻³.

Second, a 3 µm thick fifth level of metal (this layer corresponds to conductive layer 130) was added to a 4-level aluminum back-end (an integrated circuit containing four other layers of metallization). The 5^{th} level uses relaxed lithographic design rules that are sufficient for inductor layouts.

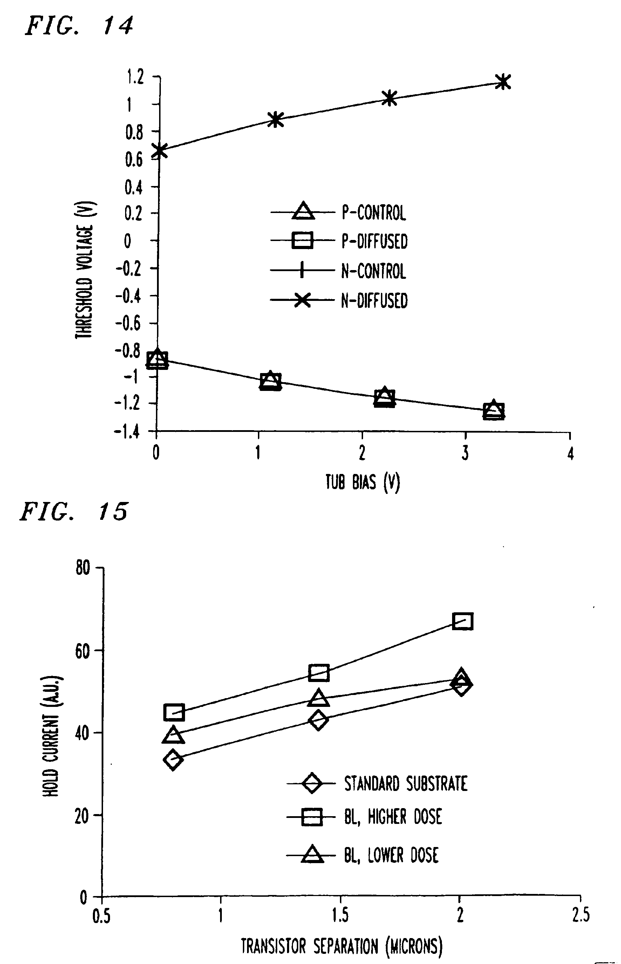

As is shown in Fig. 14, measurements on MOS devices formed on the modified substrate showed no significant changes in the tub bias dependence of the threshold voltage. As is shown in Fig. 15, latch up hold current was measured as a function of transistor separation. The devices fabricated on the modified substrate had better hold current than the standard substrate. The hold current also decreased for smaller dopant doses in the buried layer 105.

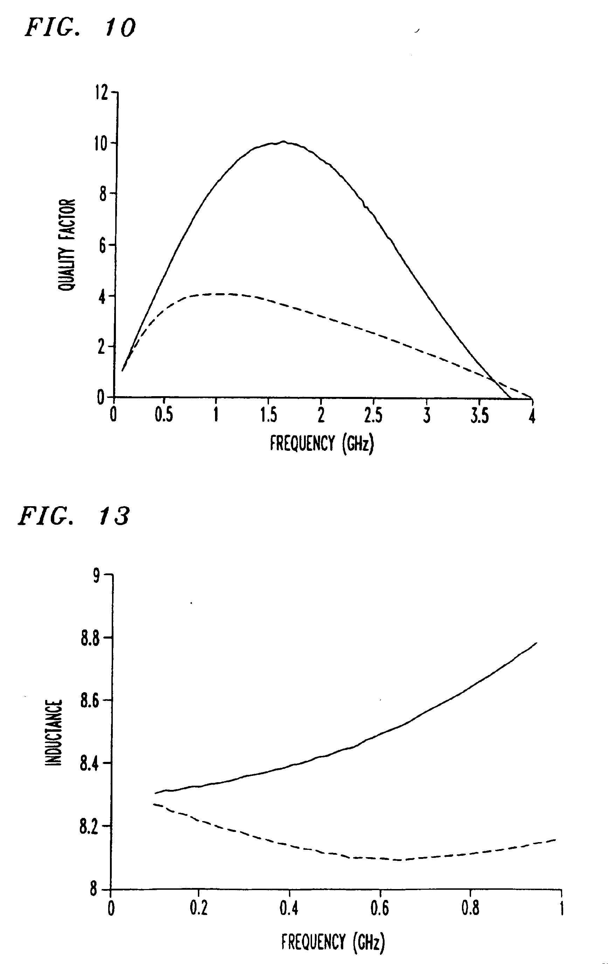

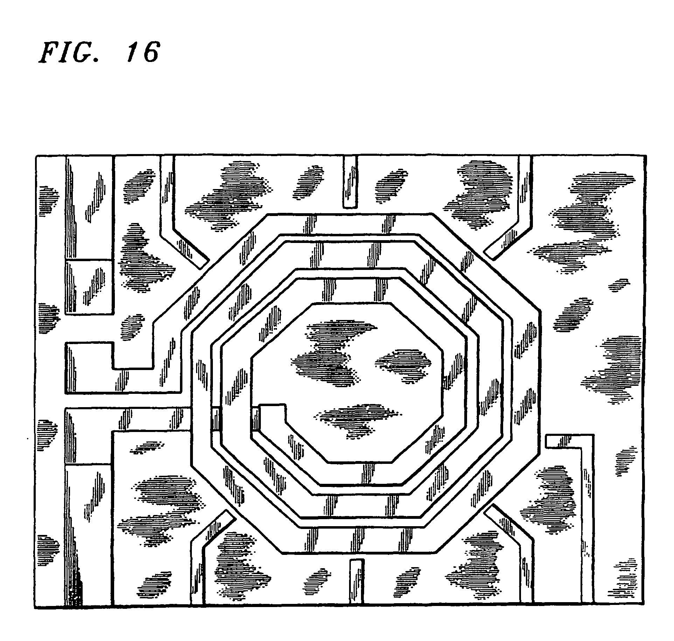

Fig. 16 is a micrograph top view of the finished inductor. As is shown in Fig. 10, the peak Q of an 8nH inductor increased from 4nH in a standard substrate to 10nH for the modified substrate, with the position of the peak increasing from 0.8GHz to 1.5GHz, As is shown in Fig. 13, the typical decrease of L with increasing frequency, observed for a standard substrate and indicative of substrate losses, does not occur in the modified substrate. The results demonstrate that the modified substrate can be used to fabricate high-Q inductors while preserving CMOS I-V and latchup characteristics.

## Claims

1. A method of manufacturing an integrated circuit comprising the steps of:
(a) forming a buried layer (105) between a first (100) and second (110) doped layer wherein said buried layer has a dopant concentration greater than a dopant concentration of said first and second layers; and
(b) forming a conductive layer (130) above said buried layer (105), said buried layer and said conductive layer forming an inductor.

2. The method of claim 1 further comprising providing the conductive layer (130) having a thickness X greater than 5 µm.

3. The method of claim 2 wherein the thickness X is 5µm ≤ X ≤ 6µm.

4. The method of claim 1 wherein the buried layer (105) has a peak doping concentration greater than or equal to 1 x 10¹⁸ cm⁻³.

5. The method of claim 1 wherein the doping concentrations of the first and second layers (e.g., 110 or 100) are less than 1 x 10¹⁶ cm⁻³.

6. An integrated circuit comprising:
a buried layer (105) between a first(100) and second (110) doped layer, wherein said buried layer has a dopant concentration greater than a dopant concentration of said first and second layers and
a conductive layer (130) above said buried layer (105), said buried layer (105) and said conductive layer (130) forming an inductor.

7. The integrated circuit of claim 6 wherein the conductive layer (110 or 100) has a thickness X greater than .5µm.

8. The integrated circuit of claim 7 wherein the thickness X is .5 µm ≤ X ≤ 6µm.

9. The integrated circuit of claim 6 wherein the buried layer (105) has a peak doping concentration greater than or equal to 1 x 10¹⁸ cm⁻³.

10. The integrated circuit of claim 6 wherein the buried layer (105) has a peak doping concentration greater than the average doping concentration of the first layer (110 or 100) and the second layer (110 or 100).

11. The integrated circuit of claim 10 wherein the average doping concentrations of the first and second layer (110 or 100) are less than 1 x 10¹⁶ cm⁻³.

## Patentansprüche

1. Verfahren zum Herstellen einer integrierten Schaltung, das folgende Schritte aufweist:
(a) Bilden einer vergrabenen Schicht (105) zwischen einer ersten (100) und einer zweiten (110) dotierten Schicht, wobei die vergrabene Schicht eine Dotierstoffkonzentration aufweist, die höher ist als eine Dotierstoffkonzentration der ersten und der zweiten Schicht; und
(b) Bilden einer leitfähigen Schicht (130) über der vergrabenen Schicht (105), wobei die vergrabene Schicht (105) und die leitfähige Schicht (130) eine Induktivität bilden.

2. Verfahren nach Anspruch 1,
bei dem ferner die leitfähige Schicht (130) mit einer Dicke X von mehr als 0,5 µm vorgesehen wird.

3. Verfahren nach Anspruch 2,
wobei die Dicke X 0,5 µm ≤ X ≤ 6 µm beträgt.

4. Verfahren nach Anspruch 1,
wobei die vergrabene Schicht (105) eine Dotierungs-Spitzenkonzentration von größer als oder gleich 1x10¹⁸ cm⁻³ aufweist.

5. Verfahren nach Anspruch 1,
wobei die Dotierungskonzentrationen der ersten und der zweiten Schicht (z.B. 110 oder 100) geringer sind als 1x10¹⁶cm⁻³.

6. Integrierte Schaltung, aufweisend:
eine vergrabene Schicht (105) zwischen einer ersten (100) und einer zweiten (110) dotierten Schicht, wobei die vergrabene Schicht eine Dotierstoffkonzentration aufweist, die höher ist als eine Dotierstoffkonzentration der ersten und der zweiten Schicht; und
eine leitfähige Schicht (130) über der vergrabenen Schicht (105), wobei die vergrabene Schicht (105) und die leitfähige Schicht (130) eine Induktivität bilden.

7. Integrierte Schaltung nach Anspruch 6,
wobei die leitfähige Schicht (110 oder 100) eine Dicke X von größer als 0,5 µm aufweist.

8. Integrierte Schaltung nach Anspruch 7,
wobei die Dicke X 0,5 µm ≤ X ≤ 6 µm beträgt.

9. Integrierte Schaltung nach Anspruch 6,
wobei die vergrabene Schicht (105) eine Dotierungs-Spitzenkonzentration von größer als oder gleich 1x10¹⁸ cm⁻³ aufweist.

10. Integrierte Schaltung nach Anspruch 6,
wobei die vergrabene Schicht (105) eine Dotierungs-Spitzenkonzentration aufweist, die größer ist als die durchschnittliche Dotierungskonzentration der ersten Schicht (110 oder 100) und der zweiten Schicht (110 oder 100).

11. Integrierte Schaltung nach Anspruch 10,
wobei die durchschnittlichen Dotierungskonzentrationen der ersten und der zweiten Schicht (110 oder 100) geringer sind als 1x10¹⁶ cm⁻³.

## Revendications

1. Procédé de fabrication d'un circuit intégré comprenant les étapes consistant à :
(a) former une couche enterrée (105) entre une première (100) et une seconde (110) couche dopée où ladite couche enterrée a une concentration en dopant plus grande qu'une concentration en dopant desdites première et seconde couches ; et
(b) former une couche conductrice (130) au-dessus de ladite couche enterrée (105), ladite couche enterrée (105) et ladite couche conductrice (130) formant une inductance.

2. Procédé selon la revendication 1, comprenant en outre la réalisation de la couche conductrice (130) avec une épaisseur X supérieure à 0,5 µm.

3. Procédé selon la revendication 2, dans lequel l'épaisseur X satisfait à 0,5 µm ≤ X ≤ 6 µm.

4. Procédé selon la revendication 1, dans lequel la couche enterrée (105) a une concentration en dopant maximale supérieure ou égale à 1 x 10¹⁸ cm⁻³.

5. Procédé selon la revendication 1, dans lequel les concentrations en dopant des première et seconde couches (par exemple 110 ou 100) sont inférieures à 1 x 10¹⁶ cm⁻³.

6. Circuit intégré comprenant :
une couche enterrée (105) entre une première (100) et une seconde (110) couche dopée, dans laquelle ladite couche enterrée a une concentration en dopant supérieure à une concentration en dopant desdites première et seconde couches ; et
une couche conductrice (130) au-dessus de ladite couche enterrée (105), ladite couche enterrée (105) et ladite couche conductrice (130) formant une inductance.

7. Circuit intégré selon la revendication 6, dans lequel la couche conductrice (110 ou 100) a une épaisseur X supérieure à 0,5 µm.

8. Circuit intégré selon la revendication 7, dans lequel l'épaisseur X satisfait à 0,5 µm ≤ X ≤ 6 µm.

9. Circuit intégré selon la revendication 6, dans lequel la couche enterrée (105) a une concentration en dopant maximale supérieure ou égale à 1 x 10¹⁸ cm⁻³.

10. Circuit intégré selon la revendication 6, dans lequel la couche enterrée (105) a une concentration en dopant maximale supérieure à la concentration en dopant moyenne de la première couche (110 ou 100) et de la seconde couche (110 ou 100).

11. Circuit intégré selon la revendication 10, dans lequel les concentrations moyennes en dopant des première et seconde couches (110 ou 100) sont inférieures à 1 x 10¹⁶ cm⁻³.
